# FASCICULE DE BREVET EUROPEEN

(11) **EP 0 722 217 B1**
(45) Date de publication et mention de la délivrance du brevet: **16.08.2001**
(21) Numéro de dépôt: 96410005.1
(22) Date de dépôt: 10.01.1996
(51) Int. Cl.: H03G 7/06, H04N 5/208

(54) **Circuit de réglage du seuil de supression d'un signal**
Vorrichtung zur Einstellung der Dämpfung eines Signals
Threshold adjusting circuit of the signal attenuation characteristic

(30) Priorité: 13.01.1995 FR 9500604
(43) Date de publication de la demande: 17.07.1996
(73) Titulaire: STMicroelectronics S.A., 94250 Gentilly (FR)
(72) Inventeur: Schultz, Mark A., F-38330 Biviers (FR)
(74) Mandataire: de Beaumont, Michel

(56) Documents cités:
- EP-A- 0 271 954
- FR-A- 2 551 289
- US-A- 4 295 160
- US-A- 4 437 123
- US-A- 4 571 511

## Description

La présente invention concerne le domaine des circuits de suppression, c'est-à-dire des circuits permettant de transmettre un signal seulement lorsque son amplitude dépasse un seuil de suppression prédéterminé. La présente invention concerne plus particulièrement un circuit permettant de régler le seuil de suppression en fonction de l'amplitude du signal.

Un circuit de suppression ("coring") est notamment utilisé dans un circuit d'accentuation ("peaking") destiné à souligner les contours d'objets d'une image de télévision. Le circuit de suppression sert à éviter des effets d'accentuation néfastes provoqués par le bruit présent dans les faibles niveaux du signal à traiter.

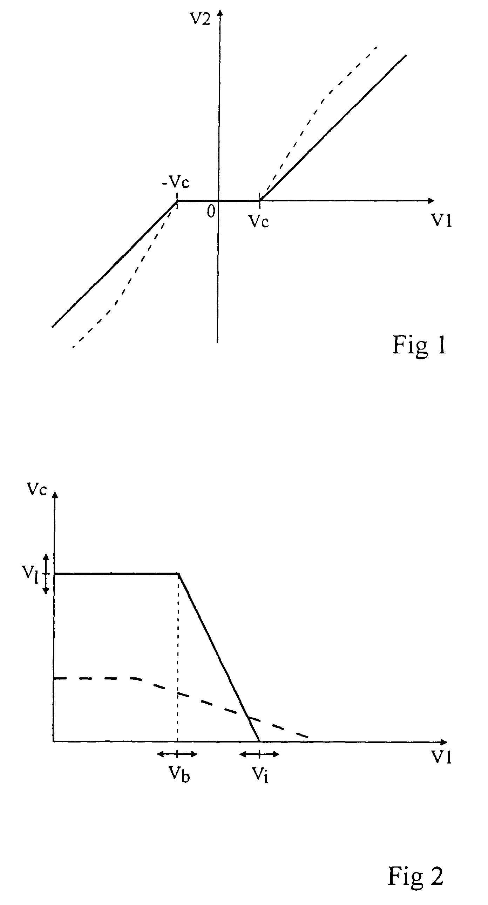

La figure 1 représente un diagramme de transfert d'un circuit de suppression. Tant qu'un signal d'entrée V1 du circuit est inférieur, en valeur absolue, à une valeur de suppression Vc, le circuit de suppression fournit une sortie V2 nulle. Dès que la valeur Vc est dépassée, la sortie V2 varie en fonction du signal V1.

Le diagramme en trait plein de la figure 1 correspond à celui qui est obtenu lorsque la valeur de suppression Vc est constante. Dans ce cas, la sortie V2 correspond à la partie du signal V1 qui excède la valeur Vc.

Les nouvelles normes de télévision tendent à imposer que le diagramme de transfert soit tel que celui représenté en pointillés à la figure 1. Lorsque le signal V1 dépasse la valeur de suppression Vc, cette valeur de suppression est diminuée jusqu'à une valeur nulle, de manière que la sortie V2 atteigne une réplique exacte du signal V1 lorsque l'amplitude de ce signal V1 croît.

Pour cela, les normes susmentionnées préconisent une caractéristique de variation de la valeur de suppression Vc en fonction du signal d'entrée V1.

Une solution pour réaliser ladite caractéristique de transfert est divivulguée dans la publication US-A-4 295 160.

La figure 2 est destinée à illustrer cette caractéristique. Jusqu'à une valeur de rupture V_{b} du signal V1, la valeur de suppression Vc est constante et égale à une valeur limite Vₗ. A partir de la valeur V_{b}, la valeur de suppression Vc diminue linéairement et s'annule pour une valeur d'interception Vᵢ du signal V1.

La valeur limite Vₗ doit pouvoir être fixée entre 0 et 7 % de l'amplitude maximale du signal V1, la valeur d'interception Vᵢ doit pouvoir être fixée entre 45 et 85 % de l'amplitude maximale du signal V1, et la valeur de rupture doit pouvoir être fixée entre 0 et la valeur Vᵢ. Ainsi, la caractéristique de la figure 2 peut avoir plusieurs allures en fonction des valeurs Vₗ, V_{b} et Vᵢ. La figure 2 représente deux exemples d'allure, l'un en trait plein et l'autre en trait mixte.

Un objet de la présente invention est de réaliser un circuit particulièrement simple permettant d'obtenir la caractéristique de la figure 2.

Pour atteindre cet objet, la présente invention prévoit un circuit comprenant un étage différentiel asymétrique ayant une branche à faible gain et une branche à fort gain. La branche à faible gain est commandée par la tension d'entrée et alimente une première charge, et la branche à fort gain alimente une deuxième charge de même nature que la première et est commandée par une tension correspondant au début de la portion à décroissance. Une première source de courant établit le courant de repos de l'étage différentiel asymétrique, ce courant de repos correspondant à la fin de la portion à décroissance. Un étage différentiel symétrique a une première branche commandée par ladite branche de faible gain et fournissant le signal de sortie du circuit. Une deuxième branche de l'étage symétrique est commandée par ladite branche de fort gain. Le courant de repos de l'étage différentiel symétrique est établi à une valeur correspondant à l'amplitude maximale du signal de sortie.

Selon un mode de réalisation de la présente invention, l'étage différentiel asymétrique comprend deux transistors dont un premier, associé à la branche de fort gain, est relié entre la deuxième charge et la première source de courant, et dont le deuxième transistor, associé à la branche de faible gain, est relié à la première source de courant par une résistance et à la première charge.

Selon un mode de réalisation de la présente invention, les première et deuxième charges sont des diodes et l'étage différentiel symétrique comprend deux transistors reliés de manière symétrique à une deuxième source de courant établissant le courant de repos de l'étage différentiel symétrique.

Ces objets, caractéristiques et avantages ainsi que d'autres de la présente invention seront exposés plus en détail dans la description suivante de modes de réalisation particuliers, faite à titre non-limitatif à l'aide des figures jointes parmi lesquelles :
la figure 1, précédemment décrite, représente un diagramme de transfert d'un circuit de suppression ;
la figure 2, précédemment décrite, représente une caractéristique de variation d'une valeur de suppression, préconisée par les normes actuelles dans le domaine de la télévision ; et
la figure 3 représente un mode de réalisation de circuit selon l'invention permettant d'obtenir la caractéristique de la figure 2.

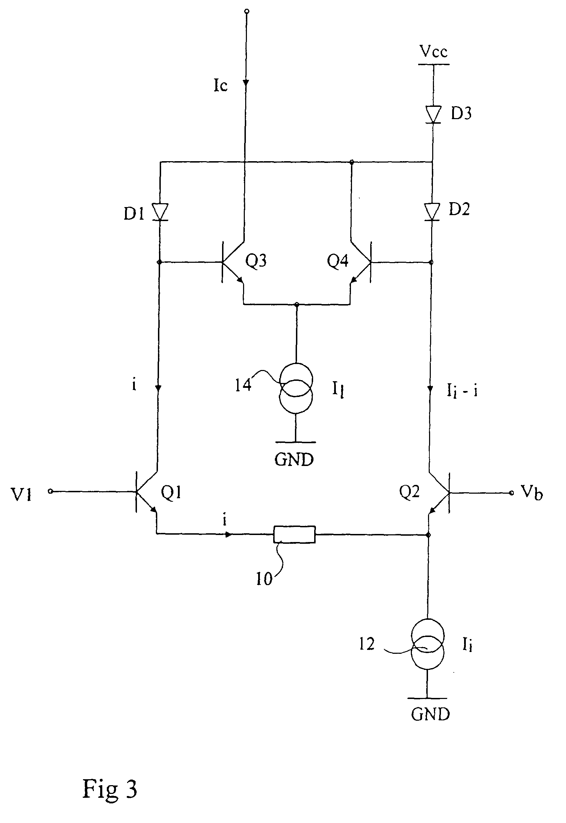

La figure 3 représente un circuit fournissant un courant Ic qui pourra commander tout circuit de suppression classique, soit directement, soit après une conversion en tension, pour fixer la valeur de suppression Vc (figures 1 et 2). Le circuit de suppression, non concerné par l'invention, n'est pas décrit.

Le signal d'entrée du circuit de suppression, une tension V1, est appliquée sur la base d'un transistor NPN Q1 formant avec un transistor Q2 un étage différentiel asymétrique. L'émetteur du transistor Q2 est relié à l'émetteur du transistor Q1 par une résistance 10 et à un potentiel d'alimentation bas GND par une source de courant 12 de valeur Iᵢ correspondant à la valeur Vᵢ de la caractéristique de la figure 2. La base du transistor Q2 reçoit une tension V_{b} correspondant à la valeur V_{b} de la caractéristique de la figure 2.

Les collecteurs des transistors Q1 et Q2 sont reliés respectivement aux bases de deux transistors NPN Q3 et Q4 formant un étage différentiel symétrique. Les émetteurs de ces transistors Q3 et Q4 sont reliés au potentiel GND par une source de courant 14 de valeur Iₗ correspondant à la valeur Vₗ de la caractéristique de la figure 2. Le collecteur du transistor Q3 fournit le courant Ic correspondant à la valeur de suppression Vc. Ce courant Ic, le cas échéant, est converti en tension ou recopié par un miroir de courant, non représenté, pour qu'il soit restitué avec une polarité ou un gain adéquat.

Les valeurs Iᵢ, V_{b} et Iₗ sont fournies par des sources indépendantes les unes des autres, ce qui permet de régler en toute liberté chacun des points particuliers de la caractéristique de la figure 2.

Les bases des transistors Q3 et Q4 sont reliées au collecteur du transistor Q4 par deux diodes respectives D1 et D2 polarisées. Le collecteur du transistor Q4 est en outre relié à un potentiel d'alimentation haut Vcc par une diode polarisée D3. Ces diodes D1 à D3 sont formées, par exemple, de transistors NPN dont chacun a sa base reliée à son collecteur.

Lorsque la tension V1 est inférieure à la tension V_{b}, aucun courant ne circule dans la résistance 10. La totalité du courant Iᵢ de la source 12 passe dans le transistor Q2 et dans la diode D2. La diode D1 est polarisée par le seul courant de base du transistor Q3. Le courant dans la diode D1 étant nettement plus faible que celui dans la diode D2, la tension de base du transistor Q3 est nettement supérieure à la tension de base du transistor Q4. Il en résulte que le transistor Q3 dérive la totalité du courant Iₗ de la source 14.

Cet état du circuit de la figure 3 est maintenu quelle que soit la tension V1 inférieure à la tension V_{b}. On obtient donc la partie horizontale de la caractéristique de la figure 2, correspondant à un courant Ic constant, égal à la valeur limite Iₗ.

Lorsque la tension V1 devient supérieure à la tension V_{b}, il s'établit un courant i dans la résistance 10, égal à (V1-V_{b})/R, où R est la valeur de la résistance 10. Alors, un courant i traverse la diode D1 et un courant Iᵢ-i traverse la diode D2. Le courant dans la diode D1 augmente tandis que le courant dans la diode D2 diminue. En conséquence, la tension de base du transistor Q3 diminue tandis que la tension de base du transistor Q4 augmente. Une fraction croissante du courant Iₗ de la source 14 passe maintenant par le transistor Q4, ce qui diminue le courant Ic.

Il arrive un moment où la tension V1 est suffisamment grande pour que tout le courant Iᵢ de la source 12 passe par le transistor Q1. Dans ce cas, la diode D1 est traversée par le courant Iᵢ, tandis que la diode D2 n'est traversée que par le courant de polarisation du transistor Q4. Le transistor Q4 dérive la totalité du courant Iₗ de la source 14, et le courant Ic est nul, même si la tension V1 continue à croître.

Le montage de l'étage différentiel Q3, Q4 et des diodes D1 et D2 permet d'obtenir une transition linéaire entre le moment où le courant de collecteur du transistor Q1 devient non nul pour V1=V_{b}, et le moment où le courant de collecteur du transistor Q2 devient nul pour V1=V_{b}+RIᵢ. Ainsi, le circuit de la figure 3 permet bien d'obtenir les parties à décroissance linéaire puis nulle de la caractéristique de la figure 2.

Les diodes D1 et D2 pourraient être remplacées par des résistances, mais il est alors plus délicat de déterminer les transitions entre le moment où un seul des transistors Q3 et Q4 est conducteur et où ces deux transistors sont conducteurs, c'est-à-dire les valeurs V_{b} et Vᵢ déterminant le début et la fin de la partie décroissante de la caractéristique de la figure 2.

La diode D3 est optionnelle. Elle sert à améliorer la réjection des variations de la tension d'alimentation Vcc et à diminuer les tensions de base des transistors Q3 et Q4, de manière que le collecteur du transistor Q3 puisse, le cas échéant, commander l'entrée d'un miroir de courant relié au potentiel Vcc, sans que le transistor Q3 entre en saturation.

De nombreuses variantes et modifications de la présente invention apparaîtront à l'homme du métier. Par exemple, les diodes D1 et D2 peuvent être remplacées par des résistances et l'étage différentiel Q3, Q4 adapté en conséquence pour établir la partie décroissante de la caractéristique.

Bien que l'invention a été décrite en relation avec un circuit de suppression, elle s'applique à toute situation où il faut fournir un signal ayant une portion à amplitude maximale constante, suivie d'une portion à décroissance jusqu'à une valeur nulle constante lorsque le signal d'entrée croît à partir de zéro.

## Revendications

1. Circuit pour fournir un signal (Ic) ayant une portion à amplitude maximale constante, suivie d'une portion à décroissance jusqu'à une valeur nulle constante lorsqu'une tension d'entrée (V1) croît à partir de zéro caractérisé en ce qu'il comprend
- un étage différentiel asymétrique (Q1, Q2) ayant une branche (Q1) à faible gain et une branche à fort gain (Q2), la branche à faible gain étant commandée par la tension d'entrée et alimentant une première charge (D1), et la branche à fort gain alimentant une deuxième charge (D2) de même nature que la première et étant commandée par une tension (V_{b}) correspondant au début de la portion à décroissance ;
- une première source de courant (12) établissant le courant de repos de l'étage différentiel asymétrique, ce courant de repos (Iᵢ) correspondant à la fin de la portion à décroissance ;
- un étage différentiel symétrique (Q3, Q4) ayant une première branche (Q3) commandée par ladite branche de faible gain et fournissant ledit signal, et ayant une deuxième branche (Q4) commandée par ladite branche de fort gain ; et
- des moyens (14) pour établir le courant de repos de l'étage différentiel symétrique à une valeur (Iₗ) correspondant à ladite amplitude maximale.

2. Circuit selon la revendication 1, caractérisé en ce que l'étage différentiel asymétrique comprend deux transistors dont un premier (Q2), associé à la branche de fort gain, est relié entre la deuxième charge et la première source de courant (12), et dont le deuxième transistor (Q1), associé à la branche faible gain, est relié à la première source de courant par une résistance (10) et à la première charge.

3. Circuit selon la revendication 1, caractérisé en ce que les première et deuxième charges sont des diodes (D1, D2) et en ce que l'étage différentiel symétrique comprend deux transistors (Q3, Q4) reliés de manière symétrique à une deuxième source de courant (14) établissant le courant de repos de l'étage différentiel symétrique.

## Patentansprüche

1. Eine Schaltung zur Lieferung eines Ausgangssignals (Ic) mit einem Teil mit einer konstanten maximalen Amplitude gefolgt von einem Teil, der auf einen konstanten Nullwert abfällt, wenn eine Eingangsspannung (V1) von Null aus ansteigt, **dadurch gekennzeichnet**, daß folgendes vorgesehen ist:
eine asymmetrische Differentialstufe (Q1, Q2) mit einem eine geringe Verstärkung aufweisenden Zweig (Q1) und mit einem eine hohe Verstärkung aufweisenden Zweig (Q2), wobei der die niedrige Verstärkung aufweisende Zweig durch die Eingangsspannung gesteuert wird und eine erste Last (D1) versorgt, und wobei der eine hohe Verstärkung aufweisende Zweig eine zweite Last (D2) von gleicher Natur wie die erste Last versorgt, und zwar gesteuert durch eine Spannung (V_{b}) entsprechend dem abnehmenden Teil;
eine erste Stromquelle (12), die den Ruhestrom der asymmetrischen Differentialstufe vorsieht, wobei der Ruhestrom (Iᵢ) dem Ende des abnehmenden Teils entspricht;
eine symmetrische Differentialstufe (Q3, Q4) mit einem durch den eine niedrige Verstärkung aufweisenden Zweig gesteuerten ersten Zweig (Q3) zur Lieferung des erwähnten Ausgangssignals und mit einem zweiten durch den eine hohe Verstärkung aufweisenden Zweig gesteuerten Zweig (Q4); und
Mittel (14) zum Vorsehen des Ruhestroms der symmetrischen Differentialstufe mit einem der erwähnten Maximalamplitude entsprechenden Wert (I₁).

2. Schaltung nach Anspruch 1, dadurch gekennzeichnet, daß die asymmetrische Differentialstufe Transistoren aufweist, wobei der erste Transistor (Q2) mit dem eine hohe Verstärkung aufweisenden Zweig assoziiert ist und zwischen die zweite Last und die erste Stromquelle (12) geschaltet ist, und wobei der zweite Transistor (Q1) mit dem eine niedrige Verstärkung aufweisenden Zweig assoziiert ist und mit der ersten Stromquelle durch einen Widerstand (10) und mit der ersten Last verbunden ist.

3. Schaltung nach Anspruch 1, dadurch gekennzeichnet, daß die ersten und zweiten Lasten Dioden (D1, D2) sind, und wobei die symmetrische Differentialstufe zwei Transistoren (Q3, Q4) aufweist, und zwar symmetrisch verbunden mit einer zweiten Stromquelle (14), die den Ruhestrom der symmetrischen Differentialstufe vorsieht.

## Claims

1. A circuit for providing an output signal (Ic) having a portion with a constant maximum amplitude, followed by a portion decreasing down to a constant zero value when an input voltage (V1) increases from zero, characterized in that it includes:
- an asymmetrical differential stage (Q1, Q2) having a low gain branch (Q1) and a high gain branch (Q2), the low gain branch being controlled by the input voltage and supplying a first load (D1), and the high gain branch supplying a second load (D2) of same nature as the first load and being controlled by a voltage (V_{b}) corresponding to the decreasing portion;
- a first current source (12) which establishing the quiescent current of the asymmetrical differential stage, said quiescent current (Iᵢ) corresponding to the end of the decreasing portion;
- a symmetrical differential stage (Q3, Q4) having a first branch (Q3) controlled by said low gain branch and providing said output signal, and having a second branch (Q4) controlled by the high gain branch; and
- means (14) for establishing the quiescent current of the symmetrical differential stage at a value (I₁) corresponding to said maximum amplitude.

2. The circuit of claim 1, characterized in that the asymmetrical differential stage comprises transistors, wherein the first transistor (Q2), associated with the high gain branch, is connected between the second load and the first current source (12), and the second transistor (Q1), associated with the low gain branch, is connected to the first current source through a resistor (10) and to the first load.

3. The circuit of claim 1, characterized in that the first and second loads are diodes (D1, D2) and wherein the symmetrical differential stage comprises two transistors (Q3, Q4) symmetrically connected to a second current source (14) which establishes the quiescent current of the symmetrical differential stage.
